(19) Europäisches Patentamt / European Patent Office / Office européen des brevets

(11) **EP 3 053 265 B1**

(12) **EUROPÄISCHE PATENTSCHRIFT**

(45) Veröffentlichungstag und Bekanntmachung des Hinweises auf die Patenterteilung:
**21.02.2018 Patentblatt 2018/08**

(21) Anmeldenummer: **14781138.4**

(22) Anmeldetag: **01.10.2014**

(51) Int Cl.:
**H03F 1/02** (2006.01)

(86) Internationale Anmeldenummer:
**PCT/EP2014/071015**

(87) Internationale Veröffentlichungsnummer:
**WO 2015/049272 (09.04.2015 Gazette 2015/14)**

(54) **SEQUENTIELLER BREITBANDIGER DOHERTY LEISTUNGSVERSTÄRKER MIT EINSTELLBAREM AUSGANGSLEITUNGS-BACK-OFF**

SEQUENTIAL BROADBAND DOHERTY POWER AMPLIFIER HAVING AN ADJUSTABLE OUTPUT POWER BACKOFF

AMPLIFICATEUR DE PUISSANCE DOHERTY SÉQUENTIEL À LARGE BANDE AVEC RÉDUCTION DE LA PUISSANCE DE SORTIE RÉGLABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.10.2013 DE 102013220160**

(43) Veröffentlichungstag der Anmeldung:
**10.08.2016 Patentblatt 2016/32**

(73) Patentinhaber: **RWTH Aachen
52062 Aachen (DE)**

(72) Erfinder:
• NEGRA, Renato
  52074 Aachen (DE)
• NGHIEM, Xuan Anh
  52062 Aachen (DE)

(74) Vertreter: **Schmelcher, Thilo
RCD-Patent
Postfach 3106
52118 Herzogenrath (DE)**

(56) Entgegenhaltungen:
US-A1- 2003 210 096   US-A1- 2010 176 885
US-A1- 2011 199 156   US-B1- 7 330 071

• JANGHEON KIM ET AL: "Analysis of a Fully Matched Saturated Doherty Amplifier With Excellent Efficiency", IEEE TRANSACTIONS ON MICROWAVE THEORY AND TECHNIQUES, IEEE SERVICE CENTER, PISCATAWAY, NJ, US, Bd. 56, Nr. 2, 1. Februar 2008 (2008-02-01), Seiten 328-338, XP011200076, ISSN: 0018-9480, DOI: 10.1109/TMTT.2007.914361
• KANG D ET AL: "Design of Doherty Power Amplifiers for Handset Applications", IEEE TRANSACTIONS ON MICROWAVE THEORY AND TECHNIQUES, IEEE SERVICE CENTER, PISCATAWAY, NJ, US, Bd. 58, Nr. 8, 1. August 2010 (2010-08-01), Seiten 2134-2142, XP011313061, ISSN: 0018-9480
• "Doherty amplifier with cooperative power tracking and bias adaption for high efficiency", RESEARCH DISCLOSURE, MASON PUBLICATIONS, HAMPSHIRE, GB, Bd. 578, Nr. 37, 1. Juni 2012 (2012-06-01), Seite 453, XP007141360, ISSN: 0374-4353
• EDMUND NEO W C ET AL: "A Mixed-Signal Approach Towards Linear and Efficient -Way Doherty Amplifiers", IEEE TRANSACTIONS ON MICROWAVE THEORY AND TECHNIQUES, IEEE SERVICE CENTER, PISCATAWAY, NJ, US, Bd. 55, Nr. 5, 1. Mai 2007 (2007-05-01), Seiten 866-879, XP011180985, ISSN: 0018-9480, DOI: 10.1109/TMTT.2007.895160

EP 3 053 265 B1

- **KHALED BATHICH ET AL: "Wideband harmonically-tuned GaN Doherty power amplifier", MICROWAVE SYMPOSIUM DIGEST (MTT), 2012 IEEE MTT-S INTERNATIONAL, IEEE, 17. Juni 2012 (2012-06-17), Seiten 1-3, XP032216901, DOI: 10.1109/MWSYM.2012.6259385 ISBN: 978-1-4673-1085-7**

**Beschreibung**

Die Erfindung betrifft einen sequentiellen breitbandigen Doherty Leistungsverstärker mit einstellbarem Ausgangsleistungs-Back-Off.

Hintergrund der Erfindung

Moderne drahtlose Kommunikationssysteme, wie solche, die beispielsweise auf W-CDMA, WiMax oder LTE basieren, wurden mit dem Ziel entwickelt hohe Datenraten bei einer effizienten Spektrums-Nutzung bereitzustellen.
Dies wird in aller Regel durch eine Vielzahl von komplexen Modulationsarten erreicht, die hierfür verwendet werden. Dabei ist festzustellen, dass diese komplexen Modulationsarten Signale mit einem hohen Verhältnis (peak-to-average power ratio - PAR) von Spitzenleistung (PEP - Peak Envelope Power) zu Durchschnittsleistung ($P_{avg}$) in der Größenordnung von circa 6 - 12 dB verwenden.
In vielen Bereichen der drahtlosen Kommunikationstechnik ist die Linearität des Übertragungsverhaltens eine der Kernforderungen. Insbesondere bei digitalen Übertragungssystemen ist dies von eminenter Wichtigkeit.
Nichtlinearitäten in Sendern begünstigen unerwünschte Aussendungen, welche die Verbindungsqualität von anderen Teilnehmern bzw. anderen Übertragungsdiensten beeinträchtigen.
Zudem werden durch die Nichtlinearitäten Verzerrungen bewirkt, die sich negativ auf die Qualität der eigenen Verbindung auswirken.
Bisher wurde diesem Problem dadurch begegnet, dass die Hochfrequenz Endstufen gegenüber der mittleren Ausgangsleistung überdimensioniert wurden. So z.B. sind Ausgangsleistungsreserven (Back off, BO} von 10 dB oder mehr keine Seltenheit, um die geforderte Linearität sicherzustellen.
Diese Überdimensionierung des Systems hat zahlreiche Nachteile. Zum einen sind die Herstellungskosten höher. Zum anderen ist die Leistungsausbeute gering, d.h. der Wirkungsgrad eines Senders nimmt mit zunehmendem Back off rapide ab. Mit sinkendem Wirkungsgrad steigt die Verlustleistung an. Um die dabei entstehende Abwärme abzuleiten müssen entsprechende Kühlungen vorgesehen sein.
So müssen beispielsweise in Basisstationen Kühlaggregate eingebaut werden, deren ständiger Betrieb die Leistungsbilanz der Basisstation bei Einbezug der notwendigen Kühlleistung noch weiter verschlechtert. Typische Werte für den Wirkungsgrad von modernen Basisstationen liegen deshalb oft im einstelligen Prozentbereich.
Um diesem Problem zu begegnen wurden in der Vergangenheit große Anstrengungen unternommen. Unter anderem wurden verschiedene Ansätze vorgestellte, wie z.B. envelope elimination and restoration (EER), outphasing oder LINC (linear amplification using nonlinear components) als auch eine aktive Lastmodulation.
Diese Ansätze sind jedoch komplex und können nicht ohne weiteres in bestehende Systeme als Ersatz für andere Leistungsverstärker integriert werden, sondern erfordern umfangreiche Anpassungen.
Andere Ansätze auf Basis von sogenannten Doherty Leistungsverstärkern zeigen jedoch nur bei Einsatz von sogenannten symmetrischen Doherty Leistungsverstärkern lediglich einen Back-Off von 6 dB und sind daher für Systeme mit einer höheren Back-Off-Anforderung nicht verwendbar.
Dies ist nur mit sogenannten unsymmetrischen Doherty Leistungsverstärkern darstellbar. Jedoch ist dies in aller Regel nur zu Lasten des Wirkungsgrades, der Verstärkung und/oder zu Lasten der Bandbreite möglich. Für breitbandige unsymmetrischen Doherty Leistungsverstärkern kann in aller Regel davon ausgegangen werden, dass diese ebenfalls einen Ausgangsleistungs-Back-Off in der Größenordnung um 6 dB zur Verfügung stellen.
Zwar existieren neuerdings Ansätze für digitale Doherty Leistungsverstärker, jedoch zeichnen sich diese wiederum durch eine enorme Komplexität für die notwendige unabhängige Steuerung von Amplitude und Phase zweier kohärenter Signale aus.
Es wäre daher wünschenswert einen Verstärker bereitzustellen, der breitbandig einen höher Back-Off zur Verfügung stellen kann, der einfach variiert werden kann und somit einen verbesserten mittleren Wirkungsgrad für verschiedene Modulationsverfahren bietet.
Dokumente US7330071, US2010176885 und JANGHEON KIM ET AL: "Analysis of a Fully Matched Saturated Doherty Amplifier With Excellent Efficiency" sind Beispiele von Doherty Verstärkern. Die Aufgabe wird gelöst durch einen sequentiellen breitbandigen Doherty Leistungsverstärker gemäß dem unabhängigen Anspruch mit einstellbarem Ausgangsleistungs-Back-Off gemäß Anspruch 1. Weitere vorteilhafte Ausgestaltungen sind insbesondere Gegenstand der abhängigen Ansprüche.
Nachfolgend wird die Erfindung näher unter Bezug auf die Figuren erläutert. In diesen zeigt:

Fig. 1 ein schematisches Blockschaltbild vor erfindungsgemäßen Ausführungsformen,

Fig.2 ein beispielhafter Drain-Wirkungsgrad in Prozent über der Ausgangsleistung (Output Power) in dBm für verschieden Werte eines Impedanzinverters $Z_T$,

Fig. 3 ein beispielhafter Drain-Wirkungsgrad in Prozent über der Ausgangsleistung (Output Power) in dBm für verschiede Verhältnisse der Versorgungsspannungszuführung zum ersten und zweiten Verstärkerzweig $V_{D,c}/V_{D,p}$, und

Fig. 4   eine beispielhafte Lastmodulation und die dazugehörigen Drain-Ströme gemäß einer Ausführungsform der Erfindung.

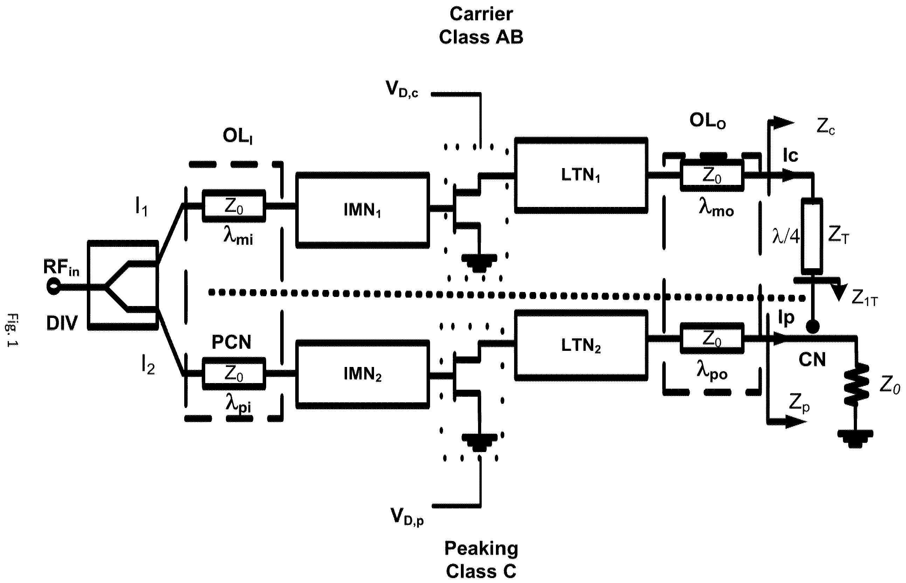

In Figur 1 ist ein schematisches Blockschaltbild gemäß Ausführungsformen der Erfindung wiedergegeben.

Dieser sequentielle breitbandige Doherty Leistungsverstärker mit einstellbarem Ausgangsleistung-Back-Off weist mindestens einen Eingang zur Entgegennahme von mindestens einem breitbandigen HF-Signal auf.

In Figur 1 wird z.B. ein breitbandiges HF-Signal RF an einem ersten Eingang $I_1$ und an einem zweiten Eingang $I_2$ bereitgestellt.

Das breitbandige HF-Signal oder die breitbandigen HF-Signal RF weisen zumindest ein mittleres Leistungsniveau ($P_{avg}$) und ein Spitzenleistungsniveau (PEP) auf, wobei das mittlere Leistungsniveau und das Spitzenleistungsniveau einen Crest-Faktor $C = PEP/P_{avg}$ definieren.

Optional kann wie in Figur 1 gezeigt ein breitbandiges HF-Signal $RF_{in}$ mittels eines (oder mehrerer) Leistungsteiler DIV den beiden Eingängen $I_1$ und $I_2$ zur Verfügung gestellt werden.

Weiterhin weist der erfindungsgemäße sequentielle Doherty Leistungsverstärker einen ersten Verstärkerzweig zur Verstärkung des Eingangssignales auf, wobei der erste Verstärkerzweig im Wesentlichen die Verstärkung für niedrige und zumindest das mittlere Leistungsniveau bereitstellt.

Dieser Verstärkerzweig ist z.B. in Figur 1 in der oberen Hälfte (im Wesentlichen oberhalb der gestrichelten Linie) dargestellt und kann z.B. als ein Verstärker auf GaN-Basis (Gallium Nitrid) ausgeführt in HEMT (High Electron Mobility Transistor) sein, z.B. ein 6 W GaN-HEMT. Dieser erste Verstärkerzweig kann beispielsweise ein Carrier Class AB Verstärker sein.

Weiterhin weist der erfindungsgemäße sequentielle Doherty Leistungsverstärker mindestens einen zweiten Verstärkerzweig zur Verstärkung des Eingangssignales auf, wobei der zweite Verstärkerzweig im Wesentlichen die Verstärkung für das Spitzenleistungsniveau bereitstellt.

Dieser Verstärkerzweig ist z.B. in Figur 1 in der unteren Hälfte (im Wesentlichen unterhalb der gestrichelten Linie) dargestellt und kann z.B. als ein Verstärker auf GaN-Basis (Gallium Nitrid) ausgeführt in HEMT (High Electron Mobility Transistor) sein, z.B. ein 10 W GaN-HEMT. Dieser erste Verstärkerzweig kann beispielsweise ein Class C Verstärker sein.

In den Ausführungsformen gemäß der Erfindung ist der Ausgang des ersten Verstärkerzweiges - gekennzeichnet durch $Z_c$, - über einen Impedanzinverter $Z_T$ mit dem Ausgang des zweiten Verstärkerzweiges - gekennzeichnet durch $Z_p$ - an der Verbindungsstelle CN verbunden ist.

Obwohl der Impedanzinverter $Z_T$ als ein konzentriertes Element dargestellt ist, können je nach Anforderung auch andere Varianten, insbesondere ein Impedanzinverternetzwerk, vorgesehen sein. Die Verbindungsstelle CN ist im Wesentlichen unmittelbar impedanzangepaßt an die Last $Z_0$ angeschlossen.

Der erster Verstärkerzweig und der zweite Verstärkerzweig verfügen jeweils über eine Versorgungsspannungszuführung, wobei zumindest eine der Versorgungsspannungszuführungen in Abhängigkeit des Crest-Faktors des zu verstärkenden Signals variabel ist und somit das Verhältnis der beiden Versorgungsspannungen variiert werden kann.

Weiterhin ist der erfindungsgemäße sequentielle Doherty Leistungsverstärker so ausgeführt, dass die Signallaufzeit durch die mindestens zwei Verstärkerzweige im Arbeitsbereich im Wesentlichen identisch ist.

Mit einer solchen Anordnung sind ohne weiteres Bandbreiten von 500 und mehr MHz und einem einstellbaren Ausgangsleistungs-Back-Off von mindestens 6 dB bis 12 dB und darüber hinaus herstellbar.

In dem vorgestellten erfindungsgemäßen sequentiellen Doherty Leistungsverstärker wird der erste Verstärkerzweig (Carrier) im Wesentlichen so dimensioniert, dass er bei einem vordefinierten Ausgangsleistungs-Back-Off gesättigt ist, wenn er in die optimale Last arbeitet. Steigt die Eingangsleistung weiter an, übernimmt mit zunehmender Leistung der zweite Verstärkerzweig die Verstärkung des Signals. Diese Übergabe geschieht durch die aktive Lastmodulation der Impedanz am Ausgang des ersten Verstärkers. Diese Impedanz nimmt mit steigender Eingangsleistung kontinuierlich ab, sodass der effektive Beitrag des ersten Verstärkerzweigs zur gesamten an die Last gelieferte Leistung abnimmt. Dann ist der Beitrag des ersten Verstärkerzweiges (Carrier) bei maximaler Leistung der Gesamtanordnung eher gering und der wesentliche Anteil der Ausgangsleistung wird durch den zweiten Verstärkerzweig bzw. weitere Verstärkerzweige zur Verfügung gestellt.

Hierdurch wird ein weicher Übergang zwischen dem ersten und dem zweiten und/oder weiteren Verstärkerzweigen innerhalb der aktiven Lastmodulationsregion zur Verfügung gestellt.

Um dies zu bewerkstelligen muss an der Verbindungsstelle CN der erste Verstärkerzweig von dem zweiten und/oder weiteren Verstärkerzweigen virtuell getrennt werden.

Mit anderen Worten muss die Impedanz $Z_T$ in Bezug auf die Verbindungsstelle CN aus der Sicht des ersten Verstärkerzweiges bei Sättigung hoch sein. Hierdurch wird es ermöglicht sowohl einen breitbandigen ersten Verstärkerzweig und einen breitbandigen zweiten Verstärkerzweig und/oder weitere breitbandige Verstärkerzweige zu kombinieren und somit den gewünschten Ausgangsleistungs-Back-Off über eine große Bandbreite zur Verfügung zu stellen.

Der erfindungsgemäße sequentielle Doherty Leistungsverstärker benötigt dabei wegen eines verminderten Impedanztranformationsverhältnisses keinerlei Impedanzanpassungsnetzwerk auf der Ausgangsseite zur Last $Z_0$ hin. Hierdurch wird die Größe der Schaltung erheblich verkleinert und zudem wird der negative Einfluss auf die verfügbare Bandbreite zum einen durch die primären Eigenschaften eines solchen Impedanzanpassungsnetzwerks als auch durch die parasitären Effekte vermieden.

Insbesondere, durch die Verwendung eines geeigneten Leistungsteiler DIV kann sichergestellt werden, dass der erste Verstärkerzweig in Sättigungsbetrieb betrieben werden kann. Hierzu kann der sequentielle Doherty Leistungsverstärker in einer Ausführungsform der Erfindung z.B. mit einem 3dB Leistungsteiler DIV ausgestattet sein, so dass beide Verstärkerzweige ein HF-Signal RF gleicher Leistung an den jeweiligen Eingängen $I_1$ und $I_2$ erhalten.

Aus Sicht der Verbindungsstelle CN ergibt sich für die virtuelle Impedanz $Z_C$ (Siehe Figur 1) in Bezug auf den ersten Verstärkerzweig im Beispiel der Ausführungsform der Figur 1 zu

$$Z_c = \begin{cases} \dfrac{Z_T^2}{Z_0} & @\, BO \\[2mm] \dfrac{Z_T^2}{\alpha Z_0} & @\, PEP \end{cases},$$

wobei BO den Betriebsmodus bei Back-Off der Ausgangsleistung bezeichnet und PEP den Betriebsmodus bei Hüllkurvenspitzenleistung (Peak Envelope Power) bezeichnet, und $\alpha = 1 + \dfrac{I_{p|sat}}{I_{c|sat}} \cdot \dfrac{V_{DD,p} - V_{k,p}}{V_{DD,c} - V_{k,c}}$ aus den Strömen $I_{p/sat}$, $I_{c/sat}$ der jeweiligen Verstärkerzweige bei Sättigung des jeweiligen Verstärkerzweiges und den jeweiligen Versorgungsspannungen $V_{DD,p}$, $V_{DD,c}$ der Verstärkerzweige und den Kniespannungen $V_{k,p}$, $V_{k,c}$ der jeweiligen Verstärkerzweige ableitbar ist.

Aus Sicht der Verbindungsstelle CN ergibt sich für die virtuelle Impedanz $Z_p$ (siehe Figur 1) in Bezug auf den zweiten Verstärkerzweig im Beispiel der Ausführungsform der Figur 1 zu

$$Z_p = \begin{cases} \infty & @\, BO \\[2mm] \beta Z_0 & @\, PEP \end{cases},$$

wobei BO den Betriebsmodus bei Back-Off der Ausgangsleistung bezeichnet und PEP den Betriebsmodus bei Hüllkurvenspitzenleistung (Peak Envelope Power PEP) bezeichnet, und $\beta = \dfrac{\alpha}{\alpha - 1}$ mit $\alpha = 1 + \dfrac{I_{p|sat}}{I_{c|sat}} \cdot \dfrac{V_{DD,p} - V_{k,p}}{V_{DD,c} - V_{k,c}}$ aus den Strömen $I_{p/sat}$, $I_{c/sat}$ der jeweiligen Verstärkerzweige bei Sättigung des jeweiligen Verstärkerzweiges und den jeweiligen Versorgungsspannungen $V_{DD,p}$, $V_{DD,c}$ der Verstärkerzweige und den Kniespannungen $V_{k,p}$, $V_{k,c}$ der jeweiligen Verstärkerzweige ableitbar ist.

Hieraus kann auch die Charakteristik des Impedanzinverters $Z_T$ abgeleitet werden:

$$Z_T = \sqrt{\frac{(V_{D,c} - V_{k,c})^2 \cdot Z_0^2}{10^{-\frac{BO}{10}} \cdot (V_{D,p} - V_{k,p})^2}},$$ wobei BO (in dB) als bestimmtes Ausgangsleistung-Back-Off bestimmt ist zu

$$BO = -20 \log_{10}\left( \frac{V_{DD,c} - V_{k,c}}{V_{DD,p} - V_{k,p}} \cdot \frac{Z_0}{Z_T} \right).$$

Wenn neben dem zweiten Verstärkerzweig (Peak) noch weitere Verstärkerzweige vorgesehen sein sollten, so ergibt sich für jeden der zweiten und weiteren Verstärkerzweige in Bezug auf den ersten Verstärkerzweig (Carrier) ein ähnliches Bild.

Weiterhin kann der sequentielle breitbandige Doherty Leistungsverstärker noch weiter Komponenten wie z.B. Offset Lines auf der Eingangsseite $OL_i$ und/oder auf der Ausgangsseite $OL_o$ und innerhalb der jeweiligen Verstärkerzweige ein Input Matching Network $INM_1$, $INS_2$ sowie ein Lastübertragungsnetzwerke $LTN_1$, $LTN_2$, denen auch Aufgaben wie eine notwendige Phasenverschiebung PCN - z.B. eine $\lambda/4$ Phasenverschiebung analog zu einer $\lambda/4$ eines Impendanzinverters $Z_T$ - zukommen kann, aufweisen, wobei es für das Verständnis der Erfindung auf diese Elemente nicht ankommt. Diese Elemente stellen soweit erforderlich sicher, dass die Signallaufzeiten in den Verstärkerzweigen nahezu identisch sind, sodass Nichtlinearitäten vermieden werden.

Wie bereits zuvor dargestellt kann mit der erfindungsgemäßen Anordnung erreicht werden, dass mit einem einzigen Eingangssignal $RF_{in}$ eine Doherty-Verstärkung mir einer Lastmodulation erzielt werden kann.

Daher kann die vorgestellte Anordnung ohne weiteres in bestehende Konzepte integriert werden und bisherige Leistungsverstärker ersetzen ohne dass ein Neuentwurf nötig wäre.

Weiterhin wird ein einstellbares Ausgangsleistungs-Back-Off zur Verfügung gestellt.

Dabei ist der Grad des Ausgangsleistungs-Back-Off als eine Funktion des Impedanzinverters $Z_T$ und/oder der gleichen oder unterschiedlichen Versorgungsspannungszuführung des ersten Verstärkerzweigs und des zweite Verstärkerzweigs einstellbar (letzteres z.B. unter Annahme, dass die Kniespannung etwa 0 V beträgt). Hierdurch kann der Ausgangsleistungs-Back-Off BO gemäß der obigen Formel ohne weiteres angepasst werden.

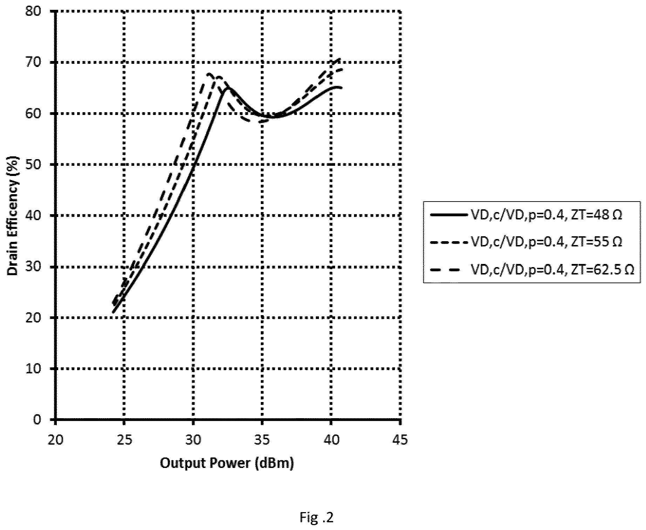

In Figur 2 ist der Drain-Wirkungsgrad in Prozent über der Ausgangsleistung Output Power in dBm für verschieden Werte eines Impedanzinverters $Z_T$ aufgezeigt. Dabei ist ersichtlich, dass mit zunehmenden Widerstand $Z_T$ des Impedanzinverters die Drain Efficiency zunimmt und die charakteristischen Maxima weiter auseinanderstreben, sodass der Ausgangsleistungs-Back-Off BO ohne weiteres höhere Werte erreichen kann als die bekannten Lösungen aus dem Stand der Technik. Auch ist somit die Einstellbarkeit über den Impedanzinverter $Z_T$ ohne weiteres möglich.

Im Fall der Figur 2 ergibt sich für $Z_T$ von beispielhaften 62.5 $\Omega$ ein Wert von circa 10 dB bei einer Bandbreite von circa 500 MHz. Hier ergibt sich auch vorteilhafterweise ein günstiges niedriges Impedanztransformationsverhältnis, das gegen 1 tendiert, und somit eine große Bandbreite ermöglicht.

Aus Figur 2 ist zudem ersichtlich, dass mit zunehmender Leistung auf der Eingangsseite der zweite Verstärkerzweig gleitend übernimmt. Dabei ist das erste Maximum der Drain-Effizienz im Wesentlichen durch den ersten Verstärkerzweig bedingt, wohingegen hin zum zweiten (Rand-) Maximum der zweite Verstärkerzweig im wesentlich ausschlaggebend ist.

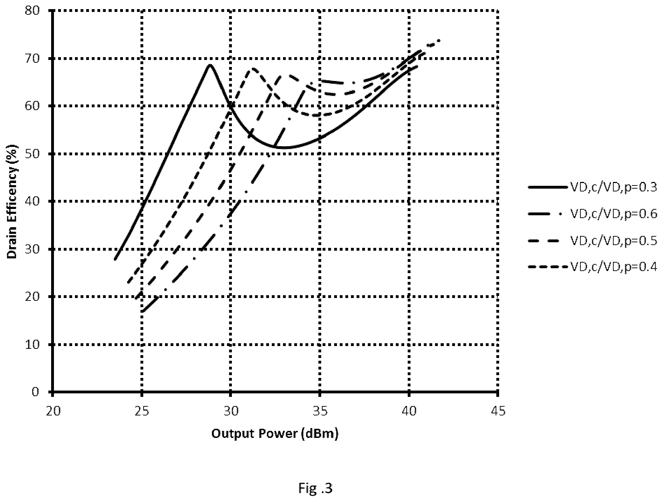

In Figur 3 ist die Drain Efficiency in Prozent über der Ausgangsleistung Output Power in dBm für verschieden Verhältnisse der Versorgungsspannungszuführung zum ersten und zweiten Verstärkerzweig $V_{D,c}$, $JV_{D,p}$ aufgezeigt. Hier wird beispielhaft der Ausgangsleistungs-Back-Off BO nur mit einer variierenden Versorgungsspannungszuführung $V_{D,c}$ (der Drain-Bias-Spannung) des ersten Verstärkerzweiges erreicht während die Versorgungsspannungszuführung $V_{D,p}$ (der Drain-Bias-Spannung) des zweiten Verstärkerzweiges konstant bleibt. Alternativ kann natürlich auch die Versorgungsspannungszuführung $V_{D,p}$ des zweiten Verstärkerzweiges variiert werden und die Versorgungsspannungszuführung $V_{D,p}$ des ersten Verstärkerzweiges konstant bleiben oder aber beide Versorgungsspannungszuführungen können entsprechend geregelt werden.

Bevorzugt wird jedoch der erste Verstärkerzweig geregelt werden, da dies besonders einfach möglich ist.

Im Fall der Figur 3 ergibt sich für $V_{D,c}/V_{D,p}$ unter der Annahme eines Impedanzinverters $Z_T$ von beispielhaften 62.5 $\Omega$ und einer konstant gehaltenen Versorgungsspannungszuführung $V_{D,p}$=30 V, dass mit abnehmenden Verhältnis der Versorgungsspannungszuführung der Ausgangsleistungs-Back-Off ansteigt.

Vor diesem Hintergrund kann ein beispielhafter Designvorgang wie folgt skizziert werden:

Zunächst wird der erste Verstärkerzweig breitbandig erstellt, sodass der erste Verstärkerzweig in etwa maximale Effizienz $P_{c,sat}$ erreicht. Dieses $P_{c,sat}$ entspricht in etwa dem gewünschten Ausgangsleistungs-Back-Off des vollständigen sequentiellen breitbandigen Doherty Leistungsverstärkers für eine definierte Last $Z_0$ (z.B. 50 $\Omega$). Dies entspricht in etwa der Bestimmung des Wertes $Z_c$. Beispielsweise wird in Figur 2 $P_{c,sat}$ dem unteren Maximum entsprechen.

In einem weiteren Schritt wird dann der zweite Verstärkerzweig breitbandig erstellt, sodass der zweite Verstärkerzweig die maximale Effizienz $P_{p,sat}$ erreicht. Dieses $P_{p,sat}$ entspricht der minimalen Ausgangsleistung des vollständigen sequentiellen breitbandigen Doherty Leistungsverstärkers für das $\beta Z_0$ System oder in etwa der Bestimmung von $Z_p$. Beispielsweise wird in Figur 2 $P_{p,sat}$ dem oberen (Rand-) Maximum entsprechen.

Anschließend werden die beiden Verstärkerzweige miteinander unter Einsatz eines Im p edanzinverters $Z_T$ miteinander kombiniert. In aller Regel kann hierfür eine $\lambda/4$ Wellenleiter, z.B. als Stripline, der sich gemäß dem obigen Formelzusammenhang ergebenden Impedanz $Z_T$ hierfür verwendet werden. Soweit notwendig kann dann an Hand der Parameter, wie z.B. der Versorgungsspannungszufuhr und/oder des Impedanzinverters $Z_T$, eine weitere Optimierung durchgeführt werden.

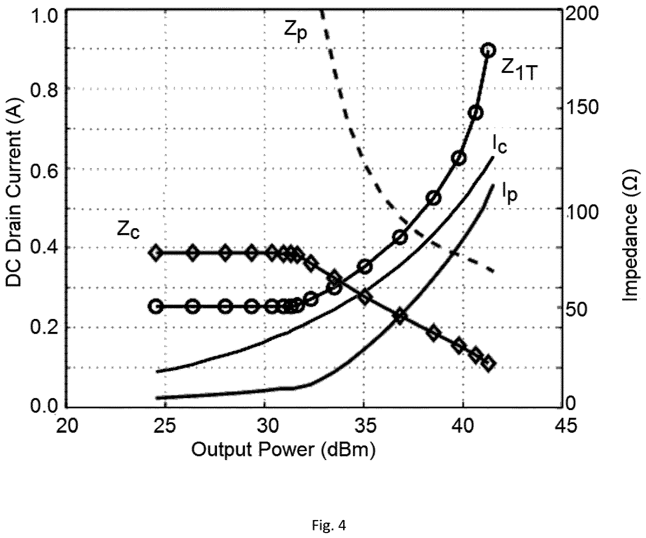

Beispielhaft ergibt sich dabei z.B. folgende Konfiguration: Im ersten Verstärkerzeig kommt ein beispielhafter 6 W GaN HEMT Verstärker zum Einsatz während im zweiten Verstärkerzeig ein 10 W GaN HEMT Verstärker zum Einsatz kommt. An den ersten Verstärkerzweig wird eine Bias-Spannung $V_{G,c}$ =-2.8 V bei einer Drain-Spannung $V_{D,c}$ = 12 V angelegt. An den zweiten Verstärkerzweig wird eine Bias-Spannung $V_{G,p}$ =-6 V bei einer Drain-Spannung $V_{D,p}$= 30 V angelegt. Diese zwei Verstärkerzweige werden für ein Ausgangsleistungs-Back-Off von 10 dB über einen Impedanzinverter $Z_T$=62.5 Ω (gemäß obiger Rechenvorschrift) verbunden. Nun kann unter der Annahme, dass der Drain-Strom der beiden Verstärkerzweige bei Sättigung in etwa identisch ist, d.h. $I_{p,sat}$=$I_{c,sat}$ α=3.5 und β=1.4 bestimmt werden, woraus sich wiederum $Z_C = \begin{cases} 77\Omega & @\ BO \\ 21.9\Omega & @\ PEP \end{cases}$ und $Z_P = \begin{cases} 175.5\Omega & @\ BO \\ 70\Omega & @\ PEP \end{cases}$ ergeben. Dies entspricht auch Figur 4 in der die Lastmodulation $Z_{1T}$, $Z_p$ und $Z_c$ aus der Sicht der Verbindungsstelle CN und der jeweilige Drain-Strom der jeweiligen Verstärkerzweiges über der Ausgansleitung in dBm aufgezeigt sind.

Hierdurch wird es ermöglicht sequentielle breitbandige Doherty Leistungsverstärker zu erstellen, bei denen das Verhältnis von Spitzenleistung zu Durchschnittsleistung mehr als 6 dB beträgt und insbesondere sequentielle breitbandige Doherty Leistungsverstärker bereitzustellen, bei denen das Verhältnis von Spitzenleistung zu Durchschnittsleistung einstellbar 6 dB bis 12 dB beträgt.

Breitbandig gemäß der Erfindung ist dabei als eine Bandbreite von 300 MHz und mehr, insbesondere 500 MHz und mehr zu verstehen.

Mit dem oben skizzierten Verfahren wurde ein Leistungsverstärker mit einer Bandbreite von mehr als 500 MHz mit 10 Watt und einem Ausgangsleistungs-Back-Off von 10 dB realisiert, um das Designkonzept zu verifizieren. Dabei konnte das erwartete Doherty-Verhalten mit einem einstellbaren Ausgangsleistungs-Back-Off von 8-11 dB über einen Frequenzbereich von 1.8 bis 2.4 GHz gezeigt werden. Dabei wurde eine Drain Efficiency von jenseits 65 % über einen Frequenzbereich von 300 MHz und mehr als 58 % über einen Frequenzbereich von 500 MHz bei Sättigung erzielt. Auch bei einem beispielhaften 10 MHz breiten LTE-Signal mit einem PAR von 7.5 dB bei 2.1 GHz wurde eine Drain Efficiency von etwa 53 % erzielt, wobei das adjacent channel leakage ratio (ACLR) -44.2/ - 48.7 dBc bei einer durchschnittlichen Ausgangsleistung von 32.7 dBm beträgt.

**Patentansprüche**

1.  Sequentieller breitbandiger Doherty Leistungsverstärker mit einstellbarem Ausgangsleistung Back-Off, aufweisend

    • mindestens einen Eingang ($I_1$, $I_2$; $RF_{in}$) zur Entgegennahme von mindestens einem breitbandigen HF-Signal, wobei das breitbandigen HF-Signal oder die breitbandigen HF-Signale ($RF_{in}$) zumindest ein mittleres Leistungsniveau ($P_{avg}$) und ein Spitzenleistungsniveau (PEP) aufweisen, wobei das mittlere Leistungsniveau ($P_{avg}$) und das Spitzenleistungsniveau (PEP) einen Crest-Faktor C= PEP/$P_{avg}$ definieren,
    • einen ersten Verstärkerzweig zur Verstärkung des Eingangssignales ($I_1$), wobei der erste Verstärkerzweig im Wesentlichen die Verstärkung für niedrige und zumindest das mittlere Leistungsniveau ($P_{avg}$) bereitstellt,
    • mindestens einen zweiten Verstärkerzweig zur Verstärkung des Eingangssignales ($I_2$), wobei der zweite Verstärkerzweig im Wesentlichen die Verstärkung für das Spitzenleistungsniveau (PEP) bereitstellt,
    • wobei der Ausgang des ersten Verstärkerzweiges über einen Impedanzinverter ($Z_T$) mit dem Ausgang des zweiten Verstärkerzweiges an einer Verbindungsstelle (CN) verbunden ist, wobei die Verbindungsstelle (CN) im Wesentlichen unmittelbar impedanzangepaßt an eine Last ($Z_0$) angeschlossen ist,
    • wobei der erster und der zweite Verstärkerzweig jeweils über eine Versorgungsspannungszuführung verfügen, wobei zumindest eine der Versorgungsspannungszuführungen in Abhängigkeit des Crest-Faktors des zu verstärkenden Signals variabel ist,
    • wobei der sequentielle Doherty Leistungsverstärker so ausgeführt ist, dass die Signallaufzeit durch die mindestens zwei Verstärkerzweige im Arbeitsbereich im Wesentlichen identisch ist, wobei die von dem ersten Verstärkerzweig wahrgenommene Ausgangsimpedanz ($Z_c$) in etwa folgendem Formelzusammenhang ent-

    spricht $Z_c = \begin{cases} \dfrac{Z_T^2}{Z_0} & @\ BO \\ \dfrac{Z_T^2}{\alpha Z_0} & @\ PEP \end{cases}$ , wobei BO den Betriebsmodus bei Back-Off der Ausgangsleistung bezeichnet und PEP den Betriebsmodus bei Hüllkurvenspitzenleistung (Peak Envelope Power) bezeichnet, und

$$\alpha = 1 + \frac{I_{p|sat}}{I_{c|sat}} \cdot \frac{V_{DD,p} - V_{k,p}}{V_{DD,c} - V_{k,c}}$$ aus den Strömen $I_{p/sat}$, $I_{c/sat}$ der jeweiligen Verstärkerzweige bei Sättigung des jeweiligen Verstärkerzweiges und den jeweiligen Versorgungsspannungen $V_{DD,p}$, $V_{DD,c}$ der Verstärkerzweige und den Kniespannungen $V_{k,p}$, $V_{k,c}$ der jeweiligen Verstärkerzweige ableitbar ist,

• wobei die von dem zweiten Verstärkerzweig wahrgenommene Ausgangsimpedanz ($Z_p$) in etwa folgendem

Formelzusammenhang entspricht $Z_p = \begin{cases} \infty & @\ BO \\ \beta Z_0 & @\ PEP \end{cases}$, wobei BO den Betriebsmodus bei Back-Off der Ausgangsleistung bezeichnet und PEP den Betriebsmodus bei Hüllkurvenspitzenleistung (Peak Envelope Power) bezeichnet, und $\beta = \dfrac{\alpha}{\alpha - 1}$ mit $\alpha = 1 + \dfrac{I_{p|sat}}{I_{c|sat}} \cdot \dfrac{V_{DD,p} - V_{k,p}}{V_{DD,c} - V_{k,c}}$ aus den Strömen $I_{p/sat}$, $I_{c/sot}$ der jeweiligen Verstärkerzweige bei Sättigung des jeweiligen Verstärkerzweiges und den jeweiligen Versorgungsspannungen $V_{DD,p}$, $V_{DD,c}$ der Verstärkerzweige und den Kniespannungen $V_{k,p}$, $V_{k,c}$ der jeweiligen Verstärkerzweige ableitbar ist,

• wobei der Übernahmepunkt (BO) zwischen dem ersten Verstärkerzweig und dem zweiten Verstärkerzweig aus den jeweiligen Versorgungsspannungen $V_{DD,p}$, $V_{DD,c}$ und den jeweiligen Kniespannungen $V_{k,c}$, $V_{k,p}$ in etwa folgendem Formelzusammenhang

$$\cdot\ BO = -20 \log_{10} \left( \frac{V_{DD,c} - V_{k,c}}{V_{DD,p} - V_{k,p}} \cdot \frac{Z_0}{Z_T} \right)$$ entspricht, wobei BO variabel ist,

• wobei der Übernahmepunkt (BO) zwischen dem ersten Verstärkerzweig und dem zweiten Verstärkerzweig aus den jeweiligen Versorgungsspannungen $V_{DD,p}$, $V_{DD,c}$ und den jeweiligen Kniespannungen $V_{k,c}$, $V_{k,p}$ in etwa folgendem Formelzusammenhang $BO = -20 \log_{10} \left( \dfrac{V_{DD,c} - V_{k,c}}{V_{DD,p} - V_{k,p}} \cdot \dfrac{Z_0}{Z_T} \right)$ entspricht, wobei BO variabel ist.

**2.** Sequentieller breitbandiger Doherty Leistungsverstärker gemäß Anspruch 1, aufweisend genau einen Eingang zur Entgegennahme eines breitbandigen HF-Signals oder mehrerer breitbandiger HF-Signale (RF) und mindestens einen Leistungsteiler (DIV) zur Verteilung des breitbandigen HF-Signals oder der mehreren breitbandigen HF-Signale an den ersten Verstärkerzweig und den zweiten Verstärkerzweig.

**3.** Sequentieller breitbandiger Doherty Leistungsverstärker gemäß einem der vorhergehenden Ansprüche, **dadurch gekennzeichnet, dass** der Impedanzinverter ($Z_T$) eine Phasenverschiebung von einer Viertel Wellenlänge zur Verfügung stellt.

**4.** Sequentieller breitbandiger Doherty Leistungsverstärker gemäß einem der vorhergehenden Ansprüche, **dadurch gekennzeichnet, dass** das Verhältnis von Spitzenleistung zu Durchschnittsleistung mehr als 6 dB beträgt.

**5.** Sequentieller breitbandiger Doherty Leistungsverstärker gemäß einem der vorhergehenden Ansprüche, **dadurch gekennzeichnet, dass** das Verhältnis von Spitzenleistung zu Durchschnittsleistung einstellbar 6 dB bis 12 dB beträgt.

**6.** Sequentieller breitbandiger Doherty Leistungsverstärker gemäß einem der vorhergehenden Ansprüche, **dadurch gekennzeichnet, dass** die verfügbare Bandbreite 500 MHz oder mehr beträgt.

**7.** Sequentieller breitbandiger Doherty Leistungsverstärker gemäß einem der vorhergehenden Ansprüche, **dadurch gekennzeichnet, dass** der Ausgang des ersten Verstärkerzweiges über einen Impedanzinverter ($Z_T$) mit dem Ausgang des zweiten Verstärkerzweiges verbunden ist und über mindestens einen weiteren Impedanzinverter mit dem Ausgang eines dritten Verstärkerzweiges verbunden ist

**8.** Verwendung eines sequentiellen breitbandiger Doherty Leistungsverstärker gemäß einem der vorhergehenden Ansprüche in einem Mobilfunkkommunikationssystem.

**Claims**

1. A sequential broadband Doherty power amplifier with adjustable output power back-off, having

- at least one input ($I_1$, $I_2$; $RF_{in}$) for receiving at least one broadband HF signal, wherein the broadband HF signal or the broadband HF signals ($RF_{in}$) have at least an average power level ($P_{avg}$) and a peak envelope power level (PEP), wherein the average power level ($P_{avg}$) and the peak envelope power level (PEP) define a crest factor $C=PEP/P_{avg}$,
- a first amplifier branch for amplifying the input signal ($I_1$), wherein the first amplifier branch substantially provides the amplification for low and at least the average power level ($P_{avg}$),
- at least one second amplifier branch for amplifying the input signal ($I_2$), wherein the second amplifier branch substantially provides the amplification for the peak envelope power level (PEP),
- wherein the output of the first amplifier branch is connected to the output of the second amplifier branch at a junction (CN) via an impedance inverter ($Z_T$), wherein the junction (CN) is connected to a load ($Z_0$) in a substantially directly impedance-matched manner,
- wherein the first amplifier branch and the second amplifier branch each have a supply voltage feed, wherein at least one of the supply voltage feeds is variable depending on the crest factor of the signal that is to be amplified,
- wherein the sequential broadband Doherty power amplifier is designed such that the signal propagation delay through the at least two amplifier branches is substantially identical in the operating range, wherein the output impedance ($Z_C$) detected by the first amplifier branch corresponds approximately to the following formula relationship:

$$Z_c = \begin{cases} \dfrac{Z_T^2}{Z_0} & @\ BO \\[3mm] \dfrac{Z_T^2}{\alpha Z_0} & @\ PEP \end{cases}$$

wherein BO stands for the operating mode with output power back-off and PEP stands for the operating mode at peak envelope power (PEP), and $\alpha = 1 + \dfrac{I_{p|sat}}{I_{c|sat}} \cdot \dfrac{V_{DD,p} - V_{k,p}}{V_{DD,c} - V_{k,c}}$ can be derived from the currents $I_{p|sat}$, $I_{c|sat}$ of the respective amplifier branches in the case of saturation of the respective amplifier branch and the respective supply voltages $V_{DD,p}$, $V_{DD,c}$ of the amplifier branches and the knee voltages $V_{k,p}$, $V_{k,c}$ of the respective amplifier branches

- wherein the output impedance ($Z_p$) detected by the second amplifier branch corresponds approximately to the following formula relationship:

$$t\ Z_p = \begin{cases} \infty & @\ BO \\[2mm] \beta Z_0 & @\ PEP \end{cases},$$

wherein BO stands for the operating mode with output power back-off and PEP stands for the operating mode at peak envelope power(PEP), and $\beta = \dfrac{\alpha}{\alpha - 1}$ can be derived with

$$\alpha = 1 + \frac{I_{p|sat}}{I_{c|sat}} \cdot \frac{V_{DD,p} - V_{k,p}}{V_{DD,c} - V_{k,c}}$$ from the currents $I_{p|sat}$, $I_{c|sat}$ of the respective amplifier branches in the case of saturation of the respective amplifier branch and the respective supply voltages $V_{DD,p}$, $V_{DD,c}$ of the amplifier branches and the knee voltages $V_{k,p}$, $V_{k,c}$ of the respective amplifier branches,

• wherein the takeover point (BO) between the first amplifier branch and the second amplifier branch from the respective supply voltages $V_{DD,p}$, $V_{DD,c}$ and the respective knee voltages $V_{k,c}$, $V_{k,p}$ corresponds approximately to the following formula relationship:

$$BO = -20 \log_{10}\left( \frac{V_{DD,c} - V_{k,c}}{V_{DD,p} - V_{k,p}} \cdot \frac{Z_0}{Z_T} \right)$$

wherein BO is variable.

2. The sequential broadband Doherty power amplifier according to claim 1, having exactly one input for receiving a broadband HF signal or multiple broadband HF signals (RF) and at least one power splitter (DIV) for distributing the one broadband HF signal or or multiple broadband HF signals to the first amplifier branch and the second amplifier branch.

3. The sequential broadband Doherty power amplifier according to any one of the preceding claims, **characterized in that** the impedance inverter ($Z_T$) makes a phase shift of a quarter wavelength available.

4. The sequential broadband Doherty power amplifier according to any one of the preceding claims, **characterized in that** the ratio of peak power to average power is greater than 6 dB.

5. The sequential broadband Doherty power amplifier according to any one of the preceding claims, **characterized in that** the ratio of peak power to average power is adjustable from 6 dB to 12 dB.

6. The sequential broadband Doherty power amplifier according to any one of the preceding claims, **characterized in that** the available bandwidth is 500 MHz or greater.

7. The sequential broadband Doherty power amplifier according to any one of the preceding claims, **characterized in that** the output of the first amplifier branch is connected to the output of the second amplifier branch via an impedance inverter ($Z_T$), and is connected to the output of a third amplifier branch via at least one further impedance inverter.

8. Use of a sequential broadband Doherty power amplifier according to any one of the preceding claims, in a mobile wireless communication system.

**Revendications**

1. Amplificateur de puissance Doherty à large bande séquentiel avec Back-Off de puissance de sortie réglable, présentant :

• au moins une entrée ($I_1$; $I_2$; $RF_{in}$) pour la réception d'au moins un signal HF large bande, dans lequel le signal HF large bande ou les signaux HF large bande ($RF_{in}$) présentent au moins un niveau de puissance moyen ($P_{avg}$) et un niveau de puissance de pointe (PEP), dans lequel le niveau de puissance moyen ($P_{avg}$) et le niveau de puissance de pointe (PEP) définissent un facteur de crête $C=PEP/P_{avg}$,
• une première branche d'amplificateur pour amplifier le signal d'entrée ($I_1$), dans lequel la première branche d'amplificateur fournit essentiellement l'amplificateur pour le niveau de puissance bas et au moins le niveau de puissance moyen ($P_{avg}$),

• au moins une deuxième branche d'amplificateur pour amplifier le signal d'entrée ($I_2$), dans lequel la deuxième branche d'amplificateur fournit essentiellement l'amplification pour le niveau de puissance de pointe (PEP),

• dans lequel la sortie de la première branche d'amplificateur est reliée par l'intermédiaire d'un inverseur d'impédance ($Z_T$) avec la sortie de la deuxième branche d'amplificateur à un point de liaison (CN), dans lequel le point de liaison (CN) est connecté essentiellement directement avec adaptation d'impédance à une charge ($Z_0$),

• dans lequel la première et la deuxième branche d'impédance disposent respectivement d'une arrivée de tension d'alimentation, dans lequel au moins une des arrivées de tension d'alimentation est variable en fonction du facteur de crête du signal à amplifier,

• dans lequel l'amplificateur de puissance Doherty séquentiel est conçu de telle sorte que le temps de propagation de signal à travers au moins deux branches d'amplificateurs est essentiellement identique dans la plage de travail, dans lequel l'impédance de sortie ($Z_c$) prise en compte par la première branche d'amplificateur correspond approximativement à la formule suivante :

$$Z_c = \begin{cases} \dfrac{Z_T^2}{Z_0} & @\ BO \\[2em] \dfrac{Z_T^2}{\alpha Z_0} & @\ PEP \end{cases},$$

dans lequel BO désigne le mode de fonctionnement au Back-Off de la puissance de sortie et PEP désigne le mode de fonctionnement en puissance de crête, et $\alpha = 1 + \dfrac{I_{p|sat}}{I_{c|sat}} \cdot \dfrac{V_{DD,p} - V_{k,p}}{V_{DD,c} - V_{k,c}}$ peut être déduit des courants $I_{p|sat}$, $I_{c|sat}$ des branches d'amplificateur respectives en cas de saturation de la branche d'amplificateur respective et des tensions d'alimentation respectives $V_{DD,p}$, $V_{DD,c}$ des branches d'amplificateur et des tensions de coude $V_{k,p}$, $V_{k,c}$ des branches d'amplificateur respectives,

• dans lequel l'impédance de sortie ($Z_p$) prise en compte par la deuxième branche d'amplificateur correspond approximativement à la formule suivante :

$$t\ Z_p = \begin{cases} \infty & @\ BO \\[1em] \beta Z_0 & @\ PEP \end{cases},$$

dans lequel BO désigne le mode de fonctionnement en Back-Off de la puissance de sortie et PEP désigne le mode de fonctionnement en puissance de crête, et $\beta = \dfrac{\alpha}{\alpha - 1}$ avec

$\alpha = 1 + \dfrac{I_{p|sat}}{I_{c|sat}} \cdot \dfrac{V_{DD,p} - V_{k,p}}{V_{DD,c} - V_{k,c}}$ peut être déduit des courants $I_{p|sat}$, $I_{c|sat}$ des branches d'amplificateur respectives en cas de saturation de la branche d'amplificateur respective et des tensions d'alimentation respectives $V_{DD,p}$, $V_{DD,c}$ des branches d'amplificateur et des tensions de coude $V_{k,p}$, $V_{k,c}$ des branches d'amplificateur respectives,

• dans lequel le point de prise en charge (B$_O$) entre la première branche d'amplificateur et la deuxième branche d'amplificateur à partir des tenions d'alimentation respectives $V_{DD,p}$. $V_{DD,C}$ et des tensions de coude respectives $V_{k,c}$, $V_{k,p}$ correspond environ à la formule suivante :

$$BO = -20\log_{10}\left(\frac{V_{DD,c} - V_{k,c}}{V_{DD,p} - V_{k,p}} \cdot \frac{Z_0}{Z_T}\right),$$

dans lequel BO est variable.

2. Amplificateur de puissance Doherty à large bande séquentiel selon la revendication 1, présentant exactement une entrée pour la réception d'un signal HF large bande ou de plusieurs signaux HF large bande (RF) et au moins un diviseur de puissance (DIV) pour distribuer le signal HF large bande ou les plusieurs signaux HF large bande sur la première branche d'amplificateur et la deuxième branche d'amplificateur.

3. Amplificateur de puissance Doherty à large bande séquentiel selon une des revendications précédentes, **caractérisé en ce que** l'inverseur d'impédance (ZT) fournit un décalage de phase d'un quart de longueur d'onde.

4. Amplificateur de puissance Doherty à large bande séquentiel selon une des revendications précédentes, **caractérisé en ce que** le rapport de la puissance de pointe sur la puissance moyenne s'élève à plus de 6 dB.

5. Amplificateur de puissance Doherty à large bande séquentiel selon une des revendications précédentes, **caractérisé en ce que** le rapport de la puissance de pointe sur la puissance moyenne est réglable entre 6 dB et 12 dB.

6. Amplificateur de puissance Doherty à large bande séquentiel selon une des revendications précédentes, **caractérisé en ce que** la largeur de bande disponible s'élève à 500 MHz ou plus.

7. Amplificateur de puissance Doherty à large bande séquentiel selon une des revendications précédentes, **caractérisé en ce que** la sortie de la première branche d'amplificateur est reliée par l'intermédiaire d'un onduleur d'impédance ($Z_T$) avec la sortie de la deuxième branche d'amplificateur et est reliée par l'intermédiaire d'un inverseur d'impédance supplémentaire avec la sortie d'une troisième branche d'amplificateur.

8. Utilisation d'un amplificateur de puissance Doherty à large bande séquentiel selon une des revendications précédentes dans un système de communication mobile.

Fig. 1

Fig .2

Fig .3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7330071 B

- US 2010176885 A

**In der Beschreibung aufgeführte Nicht-Patentliteratur**

- **JANGHEON KIM et al.** *Analysis of a Fully Matched Saturated Doherty Amplifier With Excellent Efficiency*